(19) Europäisches Patentamt
European Patent Office
Office européen des brevets

(11) **EP 3 740 837 B1**

(12) **EUROPÄISCHE PATENTSCHRIFT**

(45) Veröffentlichungstag und Bekanntmachung des Hinweises auf die Patenterteilung:
**29.12.2021  Patentblatt 2021/52**

(21) Anmeldenummer: **19701794.0**

(22) Anmeldetag: **16.01.2019**

(51) Int Cl.:
***G05F 3/30*** *(2006.01)*

(86) Internationale Anmeldenummer:
**PCT/EP2019/050988**

(87) Internationale Veröffentlichungsnummer:
**WO 2019/141697 (25.07.2019 Gazette 2019/30)**

(54) **SPANNUNGSREFERENZ-SCHALTKREIS MIT KOMBINIERTEM POWER-ON-RESET**

VOLTAGE REFERENCE CIRCUIT WITH COMBINED POWER-ON RESET

CIRCUIT DE RÉFÉRENCE DE TENSION AVEC RÉINITIALISATION À LA MISE SOUS TENSION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.01.2018  DE 102018200785**

(43) Veröffentlichungstag der Anmeldung:
**25.11.2020  Patentblatt 2020/48**

(73) Patentinhaber: **Robert Bosch GmbH 70442 Stuttgart (DE)**

(72) Erfinder: **HERMANN, Carsten 72762 Reutlingen (DE)**

(56) Entgegenhaltungen:
| | |
|---|---|
| EP-A1- 1 063 578 | EP-A1- 1 852 766 |
| DE-T2- 69 902 891 | US-A1- 2002 141 121 |
| US-A1- 2013 120 026 | US-A1- 2015 109 054 |

**Beschreibung**

Die vorliegende Erfindung betrifft einen Spannungsreferenz-Schaltkreis mit einem kombinierten Power-on-Reset-Signal.

Stand der Technik

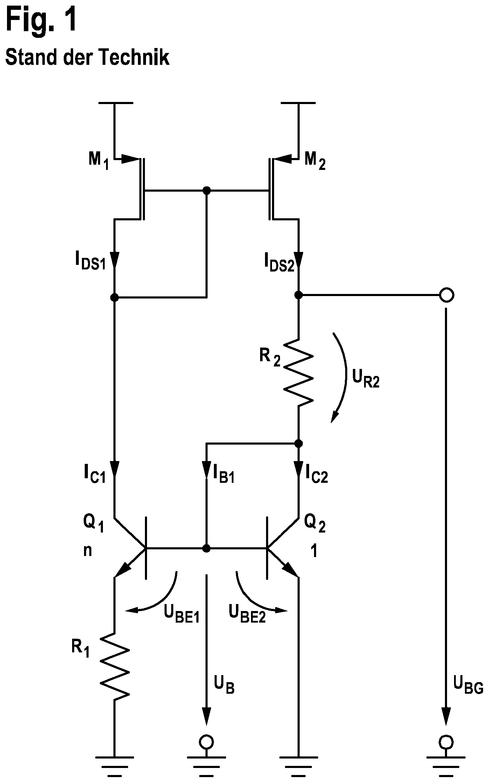

In anwendungsspezifischen integrierten Schaltkreisen (ASIC) und anderen Schaltungen wird oft eine Spannungsreferenz benötigt, die für Spannungsregler, Komparatoren, die interne Reset-Überwachung, die Ableitung von Referenzströmen und andere Zwecke herangezogen wird. Zur Bereitstellung einer Spannungsreferenz kann zum Beispiel das Bandgap-Prinzip verwendet werden. Ein Beispiel für einen gebräuchlichen Spannungsreferenz-Schaltkreis nach Stand der Technik, der nach dem Bandgap-Prinzip funktioniert, ist in Figur 1 dargestellt. Er basiert auf einer Stromspiegelschaltung, die an einen Spannungseingang, an dem eine Betriebsspannung anliegt, angeschlossen ist. Der Stromspiegel umfasst dabei baugleiche MOS-Transistoren M1, M2, deren Gates aneinander angeschlossen sind. Bei einem ersten der MOS-Transistoren M1 ist zudem das Gate an den Drain-Anschluss angeschlossen. Dieser erste MOS-Transistor M1 ist mit seinem Drain-Anschluss direkt an den Kollektor eines ersten Bipolar-Transistors Q1 angeschlossen. Der Emitter des ersten Bipolar-Transistors Q1 ist über einen ersten Widerstand an Masse angeschlossen. Die Basis des ersten Bipolar-Transistors Q1 ist mit der Basis eines zweiten Bipolar-Transistors Q2 angeschlossen. Bei dem zweiten Bipolar-Transistor Q2 ist zudem die Basis an den Kollektor angeschlossen. Der Kollektor des zweiten Bipolar-Transistors Q2 ist über einen zweiten Widerstand R2 an den Drain-Anschluss des MOS-Transistors M2 angeschlossen. Am Drain-Anschluss des MOS-Transistors M2 stellt die Schaltung die Referenzspannung UBG zur Verfügung. Mit Stromspiegeln ist es möglich, zu einem vorhandenen Strom einen identischen Strom oder zum vorhandenen Strom einen im festen Verhältnis stehenden Strom zu erzeugen. Für letztere Variante werden beispielsweise Bipolar- oder MOS-Transistoren benutzt, die in ihrer Bauform identisch oder gleich geformt, jedoch nicht flächengleich sind. So lässt sich über die Flächenverhältnisse der aktiven Flächen, Emitterflächen oder Gateflächen, das Verhältnis der Ströme allein über deren Flächen festlegen.

Die beiden Bipolar-Transistoren sind baugleich, also in ihrer Bauform identisch oder gleich. Sie sind allerdings nicht flächengleich. Die Fläche des Bipolar-Transistors Q1 ist um den Faktor n größer als die des Bipolar-Transistors Q2, wobei n eine natürliche Zahl größer eins ist. Also ist n das Größenverhältnis von Q1 / Q2.

Zusammen mit der Strom-Gegenkopplung des Bipolar-Transistors Q1, die durch den IPTAT-Schaltungswiderstand R1 hervorgerufen wird, ergeben sich unterschiedliche Strom-Spannungs-Kennlinien IC1(UB) und IC2(UB) für die Bipolar-Transistoren Q1, Q2. Der Stromspiegel aus M1 und M2 stellt für beide Bipolar-Transistoren den Arbeitspunkt ein, in dem sowohl ihre Basisspannung UB als auch ihre Kollektor-Ströme IC1 und IC2 gleich sind. Die Basis-Emitter-Spannung UBE2 von Q2 ist dabei um $\Delta$UBE = kT/q $\times$ ln(n) größer als die Basis-Emitter-Spannung UBE1 von Q1. Dabei ist k die Boltzmann-Konstante, T ist die absolute Temperatur und q ist die Ladung eines Elektrons. Die Spannungsdifferenz $\Delta$UBE legt zusammen mit der Wahl des IPTAT-Schaltungswiderstandes R1 den Kollektorstrom IC1 von Q1 beziehungsweise IC2 von Q2 und die Drain-Source-Ströme IDS1 von M1 beziehungsweise IDS2 von M2 mit IC1 = IC2 = IDS1 = IDS2 = IPTAT = 1/R1 $\times$ kT/q $\times$ ln(n) fest. Der Strom IPTAT ist stark temperaturabhängig. Er ist proportional zur absoluten Temperatur (englisch: proportional to absolute temperature (PTAT)). Innerhalb eines in vielen Anwendungen, beispielsweise im Automotive-Bereich, üblichen Temperaturbereichs von -40° C - 150° C erhöht sich dieser Strom um den Faktor zwei. Gleichzeitig ist jedoch auch die Basis-Emitter-Spannung der Bipolar-Transistoren Q1 und Q2 stark temperaturabhängig. Sie halbiert sich in dem besagten üblichen Temperaturbereich. Sowohl der Temperaturverlauf der Basis-Emitter-Spannungen als auch der Temperaturverlauf der Kollektor-Ströme sind nahezu linear. Daher lässt sich durch geeignete Wahl des Widerstands R2 bewirken, dass die Summe UBG aus dem Spannungsabfall UR2 über R2 (aufgrund des durch ihn fließenden KollektorStroms IC2) und der Basis-Emitter-Spannung UBE2 in erster Näherung unabhängig von der Temperatur ist. Diese Summenspannung UBG wird als Bandgap-Spannung bezeichnet. Sie liegt unabhängig von der verwendeten Halbleiter-Technologie bei ca. 1,25 V. Dieser Bandgap-Spannungsreferenz-Schaltkreis benötigt eine Anlaufschaltung, weil die Bedingung IC1 = IC2 auch für den Strom 0 erfüllt ist.

Der in Figur 1 gezeigte Spannungsreferenz-Schaltkreis kann erst ab einer bestimmten Betriebsspannung korrekt arbeiten. Erst wenn die Betriebsspannung groß genug ist, sodass sich der oben beschriebene Arbeitspunkt einstellen kann, kann die Referenzspannung UBG = UR2 + UBE2 erreicht werden. Dazu ist es auch erforderlich, dass sich für den MOS-Transistor M2 eine Drain-Source-Spannung UDS2 von ca. 200 mV (Drain-Source-Sättigungs-Spannung) oder mehr einstellen kann. Der in Figur 1 gezeigt Spannungsreferenz-Schaltkreis kann also erst bei einer Betriebsspannung von ca. 1,5 V störungsfrei arbeiten.

Grundsätzlich gilt, dass die Referenzspannung erst oberhalb einer bestimmten minimal erforderlichen Betriebsspannung gültig ist. Darunter liegt sie zu tief und kann nicht als Spannungsreferenz für nachfolgende Schaltkreise, wie beispielsweise Spannungsregler und/oder Komparatoren verwendet werden. Die hoch- beziehungsweise runterlaufende Betriebsspannung durchfährt in jedem Fall Spannungsbereiche, in denen die Referenzspannung ihren Zielwert nicht einnehmen kann.

In der Praxis ergibt sich das Erfordernis, feststellen zu können, wann ein Spannungsreferenz-Schaltkreis korrekt arbeitet. Hierzu muss zumindest überwacht werden, ob die zur Verfügung gestellte Betriebsspannung ihren minimal erforderlichen Wert erreicht hat. Das Erreichen der minimalen Betriebsspannung ist aber auch nur eine notwendige, jedoch keine hinreichende Bedingung für die korrekte Arbeitsweise des Spannungsreferenz-Schaltkreises und damit auch nur ein indirekter Indikator.

Mithilfe eines Power-on-Reset-Schaltkreises kann signalisiert werden, wann die zur Verfügung gestellte Betriebsspannung hoch genug ist. Oft geht es hier auch um die Verfügbarkeit des Spannungsreferenz-Schaltkreises, sodass die Betriebsspannungs-Schwelle, ab der die Betriebsbereitschaft signalisiert wird, nicht beliebig hoch angesetzt werden kann.

Die Verfügbarkeit muss gegenüber dem Sicherheitsabstand abgewogen werden. Da beide Schaltkreise unabhängig voneinander arbeiten, besteht die Gefahr, dass das Power-on-Reset-Signal des Power-on-Reset-Schaltkreises während des Hoch- beziehungsweise Runterlaufs der Betriebsspannung fehlerhaft freigegeben werden könnte. Es kann beispielsweise bei einer bestimmten Anstiegsgeschwindigkeit und Höhe der Betriebsspannung und abhängig von dem vorherigen zeitlichen Verlauf der internen Spannungskonten dazu kommen, dass trotz zu geringer Referenzspannung des Spannungsreferenz-Schaltkreises das Power-on-Reset-Signal des Power-on-Reset-Schalkreises fälschlicherweise freigegeben wird. Das kann in anderen Schaltungsteilen des ASIC Fehlfunktionen hervorrufen. Der zusätzliche Power-on-Reset-Schaltkreis benötigt einen zusätzlichen Versorgungsstrom.

Es ist in der Praxis leider festzustellen, dass Probleme, die sich während des Hoch- beziehungsweise Runterlaufs von Systemen ergeben, an dem Schaltkreis-Simulator oft nicht gefunden werden. Sie werden häufig erst sichtbar, wenn Engineering-Samples des betreffenden ASIC vorliegen, und auch dann werden sie leider teilweise nur durch Zufall gefunden. Ein Power-on-Reset-Signal, das im Hoch- beziehungsweise Runterlauf den falschen Zustand einnimmt, ist ein häufiger Grund für ein Re-Design eines ASIC.

Power-on-Reset-Schaltkreise nach Stand der Technik, die auf dem Bandgap-Prinzip beruhen, können mehr oder weniger genau signalisieren, wann die hochbeziehungsweise runterlaufende Betriebsspannung einen bestimmten Zielwert über- oder unterschreitet. Diese Power-on-Reset-Schwelle kann eine Aussage darüber treffen, ob die zur Verfügung stehende Betriebsspannung ausreicht, um einen Spannungsreferenz-Schaltkreis zu betreiben. Letztlich läuft es aber immer darauf hinaus, zwei voneinander getrennt arbeitende Schaltkreise zu kombinieren, den eigentlichen Spannungsreferenz-Schaltkreis und einen Schaltkreis zur Erzeugung des Power-on-Reset. Dies birgt jedoch das Risiko, dass sich ergibt aus der Abwägung von Verfügbarkeit und der Größe des Sicherheitsabstandes zwischen der größten für den Spannungsreferenz-Schaltkreis erforderlichen Betriebsspannung und der kleinsten Power-on Reset-Schwelle. Dynamische Effekte und endliche Genauigkeit der Power-on-Reset-Schwelle können es erforderlich machen, diesen Sicherheitsabstand zusätzlich zu vergrößern.

Das Dokument US 2013/120026 A1 offenbart einen Spannungsreferenz-Schaltkreis zur Bereitstellung einer Referenzspannung für eine anwendungsspezifisch integrierte Schaltung.

Offenbarung der Erfindung

Erfindungsgemäß wird ein Spannungsreferenz-Schaltkreis gemäß Anspruch 1 vorgeschlagen. Der Spannungsreferenz-Schaltkreis dient zur Bereitstellung einer Referenzspannung für eine anwendungsspezifische integrierte Schaltung. Der Spannungsreferenz-Schaltkreis umfasst einen Spannungseingang zum Anlegen einer Betriebsspannung, einen Masseanschluss, einen Spannungsausgang zur Bereitstellung einer Referenzspannung und einen Signalausgang zur Bereitstellung eines Power-on-Reset-Signals. Der Spannungsreferenz-Schaltkreis umfasst eine zwischen Spannungseingang und Masseanschluss angeschlossene IPTAT-Schaltung zur Erzeugung eines zur absoluten Temperatur proportionalen Stroms. Dabei ist der Spannungsreferenz-Schaltkreis ausgebildet, das Power-on-Reset-Signal nur bereitzustellen, wenn die Referenzspannung einen Zielwert erreicht hat und wenn zusätzlich in der IPTAT-Schaltung ein Strom mit einer Stromstärke fließt, die eine durch einen Spannungswert der Betriebsspannung und einen Pulldown-Widerstandswert bestimmte Mindeststromstärke erreicht oder überschreitet.

Die Erzeugung einer Referenzspannung und eines Power-on-Reset-Signals wird erfindungsgemäß in einem Schaltkreis kombiniert. Das Power-on-Reset-Signal kann daher abhängig davon, dass die Referenzspannung des Spannungsreferenz-Schaltkreises einen Zielwert erreicht hat, bei gleichzeitig in der IPTAT-Schaltung fließenden Strom erzeugt werden. Das Power-on-Reset-Signal der vorliegenden Erfindung zeigt daher die Betriebsbereitschaft der Spannungs-Referenz zuverlässig an.

Damit wird ein Auseinanderlaufen der Referenzspannung und der Power-on-Reset-Schwelle verhindert, da die sich einstellende Referenzspannung zugleich die Power-on-Reset-Schwelle bildet. Der Abgleich der Referenzspannung ist zugleich auch der Abgleich der Power-on-Reset-Schwelle. Das Erreichen der minimalen Betriebsspannung, die für den störungsfreien Betrieb des Spannungsreferenz-Schaltkreises erforderlich ist, lässt zudem eine direkte Aussage über den korrekten Hochlauf des Spannungsreferenz-Schaltkreises zu. Während des Hoch- und Runterlaufes der Betriebsspannung gibt es keine hochohmigen Knoten im Signalpfad des Power-on-Reset-Signals, die dazu führen könnten, dass das Power-on-Reset-Signal Betriebsbereitschaft signalisiert, obwohl die Referenzspannung ihren Zielwert nicht erreicht hat.

In einer bevorzugten Ausführungsform umfasst die IPTAT- Schaltung einen ersten und einen zweiten Bipolar-Transistor mit unterschiedlichen Strom-Spannungs-Kennlinien, wobei der erste Bipolar-Transistor größer als der zweite Bipolar-Transistor ist, einen IPTAT-Schaltungswiderstand, einen ersten Stromspiegel, der den durch den ersten Bipolar-Transistor fließenden Strom auf einen ersten Strompfad abbildet, der den zweiten Bipolar-Transistor umfasst, einen zweiten Stromspiegel, der mit dem Spannungseingang verbunden ist, und einen sechsten Bipolar-Transistor und einen vierten MOS-Transistor. Ein Drain-Anschluss des vierten MOS-Transistors ist mit dem zweiten Stromspiegel, ein Gate-Anschluss des vierten MOS-Transistors ist mit einem Kollektor des zweiten Bipolar-Transistors und ein Source-Anschluss des vierten MOS-Transistors ist mit den Basen des ersten, des zweiten und des sechsten Bipolar-Transistors verbunden. Dabei ist ein Emitter des sechsten Bipolar-Transistors mit dem Masseanschluss verbunden und ein Kollektor des sechsten Bipolar-Transistors ist mit der Basis des sechsten Bipolar-Transistors verbunden. Der Emitter des ersten Bipolar-Transistors ist über den ersten Widerstand mit dem Masseanschluss verbunden, während der Emitter des zweiten Bipolar-Transistors direkt mit dem Masseanschluss verbunden ist. Der Spannungsreferenz-Schaltkreis umfasst weiterhin einen zweiten Strompfad zwischen dem Spannungseingang und dem Masseanschluss, wobei der zweite Strompfad einen Pulldown-Widerstand mit dem Pulldown-Widerstandswert umfasst und wobei der zweite Stromspiegel einen durch den vierten MOS-Transistor fließenden Strom auf den zweiten Strompfad abbildet, wobei der Pulldown-Widerstandswert so gewählt ist, dass ein Spannungsabfall über dem Widerstand nicht weiter ansteigt, wenn der durch den vierten MOS-Transistor fließende Strom so hoch ist, dass der erste und der zweite Bipolar-Transistor leiten.

In der bevorzugten Ausführungsform zieht ein Pull-Down-Widerstand einen Knoten zuverlässig auf Masse, wenn der Strom in der IPTAT- Schaltung nicht ausreichend fließt (LOW-Pegel). Dabei legt eine Größe des Pull-Down-Widerstandes das Maß des Stroms fest, welches schaltungsgemäß ausreichend ist.

Der Spannungsreferenz-Schaltkreis kann weiterhin einen dritten Strompfad zwischen dem Spannungseingang und dem Masseanschluss und einen dritten Stromspiegel umfassen. Dabei kann der dritte Strompfad einen dritten Bipolar-Transistor umfassen, wobei der dritte Stromspiegel einen weiteren Strom, der durch den ersten Bipolar-Transistor fließt, vergrößert auf den dritten Strompfad abbilden kann. Der Source-Anschluss des vierten MOS-Transistors kann mit einer Basis des dritten Bipolar-Transistors verbunden sein.

Die Strommenge des weiteren Stroms, zu deren Abführung der dritte Bipolar-Transistor geeignet ist, ist durch die Kopplung des Source-Anschluss des vierten MOS-Transistors mit der Basis des dritten Bipolar-Transistors auf die zur absoluten Temperatur proportionale Strommenge, die in der IPTAT-Schaltung fließen kann, beschränkt. Da das vergrößerte Abbild des weiteren Stroms stets größer als diese Strommenge ist, kann am Kollektor des dritten Bipolar-Transistors eine Spannung anliegen, die als Indikator dienen kann, dass die Referenzspannung ihren Zielwert erreicht hat, sofern das vergrößerte Abbild des Stroms nicht abgeschnürt wird.

Der Spannungsreferenz-Schaltkreis kann mithin eine Pull-Down-Stromquelle umfassen, die genau die zur absoluten Temperatur proportionale Strommenge führen kann.

Der Spannungsreferenz-Schaltkreis kann einen ersten Schmitt-Trigger, der mit einem Knoten auf dem zweiten Strompfad verbunden ist, wobei der Knoten zwischen dem Stromspiegel und dem Pulldown-Widerstand angeordnet sein kann, und einen zweiten Schmitt-Trigger, der mit einem weiteren Knoten auf dem dritten Strompfad verbunden sein kann, umfassen. Dabei kann der weitere Knoten zwischen dem dritten Stromspiegel und dem dritten Bipolar-Transistor angeordnet sein.

Ist die Betriebsspannung groß genug, sodass der Strom in der IPTAT-Schaltung in einem ausreichenden Maß fließen kann, ruft das Abbild des Stroms an dem Pull-Down-Widerstand einen Maximalspannungsabfall hervor, sodass der Eingang des ersten Schmitt-Triggers durch das Abbild des Stroms zur positiven Betriebsspannung hin (HIGH-Pegel) gezogen wird und der Ausgang dieses ersten Schmitt-Trigger so einen HIGH-Pegel liefert.

Das vergrößerte Abbild des weiteren Stroms kann weiterhin dazu verwendet werden, den Eingang des zweiten Schmitt-Triggers dann zu einer positiven Betriebsspannung hin (HIGH-Pegel) zu ziehen, wenn dieses Abbild des weiteren Stroms größer als das Abbild des Stroms ist, den die Pull-Down-Stromquelle liefern kann, die den Eingang dieses zweiten Schmitt-Triggers in Richtung Masse zieht.

Dies ist genau dann der Fall, wenn die Referenzspannung gerade ihren Zielwert erreicht hat.

Der Spannungsreferenz-Schaltkreis kann weiterhin ein NAND-Gatter umfassen, wobei Ausgänge des ersten und des zweiten Schmitt-Triggers mit Eingängen des NAND-Gatters verbunden sein können und wobei ein Ausgang des NAND-Gatters mit dem Signalausgang zur Bereitstellung eines Power-on-Reset-Signals (RST) verbunden sein kann.

Das NAND-Gatter verknüpft die Ausgangssignale der beiden Schmitt-Trigger. Auf diese Weise wird ein Power-on-Reset-Signal erzeugt, dass zuverlässig erst dann einen LOW-Pegel annimmt (kein Reset), wenn die angelegte Betriebsspannung so groß ist, dass die Referenzspannung ihren Zielwert erreicht hat.

Dann liegt am Signalausgang genau dann ein LOW-Pegel an, wenn an den Eingängen des ersten und des zweiten Schmitt-Triggers jeweils ein HIGH-Pegel anliegt. Das Power-On-Reset Signal wird also genau dann auf Low-Pegel gesetzt, wenn die Referenzspannung gerade ihren Zielwert erreicht hat und zusätzlich in der IPTAT-Schaltung ein Strom mit ausreichender Stromstärke fließt.

Der Spannungsreferenz-Schaltkreis kann weiterhin einen vierten Strompfad zwischen dem Spannungseingang und dem Masseanschluss und einen vierten Stromspiegel umfassen. Dabei kann der vierte Strompfad einen weiteren Widerstand und einen vierten Bipolar-Transistor in Reihe geschaltet umfassen. Basis und Kollektor des vierten Bipolar-Transistors können miteinander verbunden sein. Der vierte Stromspiegel kann ausgebildet sein, den weiteren Strom auf den vierten Strompfad abzubilden. Der Spannungsreferenz-Schaltkreis kann weiterhin noch einen weiteren Knoten auf dem vierten Strompfad umfassen, der zwischen dem vierten Stromspiegel und dem weiteren Widerstand angeordnet und mit dem Spannungsausgang zur Bereitstellung einer Referenzspannung verbunden ist.

Der Spannungsreferenz-Schaltkreis kann weiterhin einen fünften Stromspiegel umfassen, der ausgebildet sein kann, das durch den vierten Strompfad fließende Abbild des weiteren Stroms verkleinert auf den dritten Strompfad abzubilden.

Zur Filterung der Betriebsspannung kann ein RC-Filter an den Spannungseingang angeschlossen sein.

Ein Zeitglied kann vorteilhaft zur Verzögerung des Power-on-Reset-Signals verwendet werden.

Eine integrierte Schaltung an einem Referenzspannungs-Schaltkreis entsprechend der vorliegenden Erfindung kann beispielsweise in einem Fahrzeug Verwendung finden.

Vorteilhafte Weiterbildungen der Erfindung sind in den Unteransprüchen angegeben und in der Beschreibung beschrieben.

Zeichnungen

Ausführungsbeispiele der Erfindung werden anhand der Zeichnungen und der nachfolgenden Beschreibung näher erläutert. Es zeigen:

Figur 1 einen Bandgap-Spannungsreferenz-Schaltkreis nach Stand der Technik, und
Figur 2 einen Spannungsreferenz-Schaltkreis mit kombiniertem Power-on-Reset-Signal gemäß einer beispielhaften Ausführungsform der vorliegenden Erfindung.

Ausführungsformen der Erfindung

Eine beispielhafte Ausführungsform der vorliegenden Erfindung liegt in Form eines Spannungsreferenz-Schaltkreises 100 zur Bereitstellung einer Referenzspannung für eine anwendungsspezifische integrierte Schaltung (ASIC) vor. Der Spannungsreferenz-Schaltkreis 100 dieser Ausführungsform umfasst einen Spannungseingang zum Anlegen einer Betriebsspannung und einen Spannungsausgang zur Bereitstellung einer Referenzspannung VBG. Der Spannungsreferenz-Schaltkreis umfasst weiterhin einen Signalausgang zur Bereitstellung eines Power-on-Reset-Signals RST. Der Spannungsreferenz-Schaltkreis ist ausgebildet, das Power-on-Reset-Signal RST nur bereitzustellen, wenn die Referenzspannung ihren Zielwert erreicht.

Zur Filterung der Betriebsspannung ist im Ausführungsbeispiel ein RC-Filter an den Spannungseingang angeschlossen. Das RC-Filter kann jedoch weggelassen werden, ohne von der vorliegenden Erfindung abzuweichen.

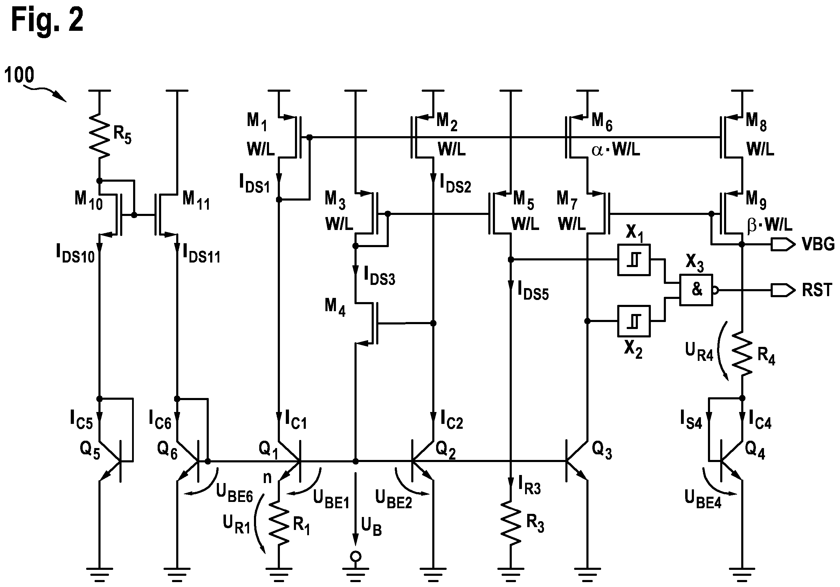

In der Figur 2 ist ein Spannungsreferenz-Schaltkreis gemäß einer beispielhaften Ausführungsform der vorliegenden Erfindung gezeigt.

Dabei ist eine zwischen Spannungseingang und Masseanschluss angeschlossene IPTAT-Schaltung zur Erzeugung eines zur absoluten Temperatur proportionalen Stroms umfasst.

Der Spannungsreferenz-Schaltkreis umfasst im Ausführungsbeispiel weiterhin zwei Schmitt-Trigger X1, X2 und ein NAND-Gatter X3. Ein Eingang des einen Schmitt-Triggers X1 ist an einen Knoten, den ersten Knoten, angeschlossen. Ein Eingang des anderen Schmitt-Triggers X2 ist an einen weiteren Knoten, den zweiten Knoten, angeschlossen. Ausgänge der Schmitt-Trigger X1, X2 sind an Eingänge des NAND-Gatters X3 angeschlossen. Ein Ausgang des NAND-Gatters X3 ist an den Signalausgang angeschlossen.

Die IPTAT-Schaltung des Ausführungsbeispiels der Erfindung umfasst einen IPTAT-Schaltungswiderstand R1 sowie einen ersten, einen zweiten, einen dritten und einen vierten MOS-Transistor M1, M2, M3, M4. Die IPTAT-Schaltung umfasst darüber hinaus einen ersten, einen zweiten und einen sechsten Bipolar-Transistor Q1, Q2 und Q6. Der erste und der zweiten Bipolar-Transistor Q1, Q2 unterscheiden sich in ihrer Größe. Das Größenverhältnis ist bevorzugt rational, noch bevorzugter natürlich. Der erste und der zweite MOS-Transistor M1, M2 weisen gleiche Beschaffenheit auf.

Der Emitter des zweiten Bipolar-Transistors Q2 ist im Ausführungsbeispiel direkt an Masse angeschlossen. Der Emitter des ersten Bipolar-Transistors Q1 ist im Ausführungsbeispiel über den IPTAT-Schaltungswiderstand R1 an Masse angeschlossen. Der Source-Anschluss des ersten MOS-Transistors M1, der Source-Anschluss des zweiten MOS-Transistors M2 und der Source-Anschluss des dritten MOS-Transistors M3 sind im Ausführungsbeispiel an den Betriebsspannungseingang angeschlossen. Der Drain-Anschluss des ersten MOS-Transistors M1 ist im Ausführungsbeispiel an den Kollektor des ersten Bipolar-Transistors Q1 angeschlossen. Der Drain-Anschluss des zweiten MOS-Transistors M2 ist im Ausführungsbeispiel direkt an den Kollektor des zweiten Bipolar-Transistors Q2 angeschlossen. Der Drain-Anschluss des dritten MOS-Transistors M3 ist im Ausführungsbeispiel an den Drain-Anschluss des vierten MOS-Transistors M4 angeschlossen.

Das Gate des ersten MOS-Transistors M1 und das Gate des zweiten MOS-Transistors M2 sind im Ausführungsbeispiel an einen dritten Knoten angeschlossen. Der Drain-Anschluss des ersten MOS-Transistors M1 ist an den dritten Knoten und der Drain-Anschluss des dritten MOS-Transistors M3 ist an das Gate des dritten MOS-Transistors M3 angeschlossen. Die Basis des ersten Bipolar-Transistors Q1 und die Basis des zweiten Bipolar-Transistors Q2 sind im Ausführungsbeispiel an einen vierten Knoten angeschlossen. Der Source-Anschluss des vierten MOS-Transistors M4 ist an den vierten Knoten und das Gate des vierten MOS-Transistors M4 ist im Ausführungsbeispiel an den Kollektor des zweiten Bipolar-Transistors Q2 angeschlossen.

In einer beispielhaften Weiterbildung des Ausführungsbeispiels umfasst der Spannungsreferenz-Schaltkreis weiterhin einen zweiten Strompfad mit einem fünften MOS-Transistor M5, der mit dem dritten MOS-Transistor M3 einen zweiten Stromspiegel bildet, und einen Pulldown-Widerstand R3. Dabei ist der Source-Anschluss des fünften MOS-Transistors M5 an den Betriebsspannungseingang angeschlossen. Das Gate des fünften MOS-Transistors M5 ist an das Gate des dritten MOS-Transistors M3 angeschlossen. Der Drain-Anschluss des fünften MOS-Transistors M5 ist an den ersten Knoten angeschlossen. Der Pulldown-Widerstand R3 ist zwischen dem ersten Knoten und Masse angeschlossen. Eine Stromstärke des in der IPTAT- Schaltung fließenden Stroms muss eine von dem Spannungswert der Betriebsspannung und dem Pulldown-Widerstandwert des Pulldown-Widerstands R3 abhängige Mindeststromstärke überschreiten, damit sich am ersten Knoten eine Spannung aufbauen kann.

In einer beispielhaften und optionalen Ausgestaltung des Ausführungsbeispiels umfasst der Spannungsreferenz-Schaltkreis weiterhin einen dritten Strompfad mit einem dritten Bipolar-Transistor Q3, einem sechsten MOS-Transistor M6 und einem siebten MOS-Transistor M7. Der Source-Anschluss des sechsten MOS-Transistors M6 ist in dieser Ausgestaltung an den Betriebsspannungseingang angeschlossen. Der sechste MOS-Transistor M6 bildet mit dem ersten MOS-Transistor M1 einen zweiten Stromspiegel. Der Drain-Anschluss des sechsten MOS-Transistors M6 ist in dieser Ausgestaltung an den Source-Anschluss des siebten MOS-Transistors M7 angeschlossen. Der Drain-Anschluss des siebten MOS-Transistors M7 ist in dieser Ausgestaltung an den zweiten Knoten angeschlossen. An den zweiten Knoten ist zudem der Kollektor des dritten Bipolar-Transistors Q3 angeschlossen. Der Emitter des dritten Bipolar-Transistors Q3 ist in dieser Ausgestaltung an Masse angeschlossen. Die Basis des dritten Bipolar-Transistors Q3 ist in dieser Ausgestaltung an den vierten Knoten angeschlossen.

Der Spannungsreferenz-Schaltkreis kann in einer optionalen, weiteren Ausgestaltung einen vierten Strompfad mit noch einem weiteren Knoten, dem fünften Knoten, einem dritten Widerstand R4, einem vierten Bipolar-Transistor Q4 und einem achten und einem neunten MOS-Transistor M8, M9 umfassen. Der Source-Anschluss des achten MOS-Transistors M8 kann an den Betriebsspannungseingang angeschlossen sein. Das Gate des achten MOS-Transistors M8 kann an den dritten Knoten angeschlossen sein. Der achte MOS-Transistor M8 bildet mit dem ersten MOS-Transistor M1 einen vierten Stromspiegel. Der Drain-Anschluss des achten MOS-Transistors M8 kann an den Source-Anschluss des neunten MOS-Transistors M9 angeschlossen sein. Das Gate des neunten MOS-Transistors M9 kann an das Gate des siebten MOS-Transistors M7 angeschlossen sein. Der siebte MOS-Transistor M7 bildet mit dem neunten MOS-Transistor M9 einen fünften Stromspiegel. Der Drain-Anschluss des neunten MOS-Transistors M9 kann an den fünften Knoten angeschlossen sein. Der Kollektor des vierten Bipolar-Transistors Q4 kann über den dritten Widerstand R4 an den fünften Knoten angeschlossen sein. Die Basis des vierten Bipolar-Transistors Q4 kann an den Kollektor des vierten Bipolar-Transistors Q4 angeschlossen sein. Der Emitter des vierten Bipolar-Transistors Q4 kann an Masse angeschlossen sein. Der Referenzspannungsausgang VBG und das Gate des neunten MOS-Transistors M9 können an den fünften Knoten angeschlossen sein.

In noch weiterer, optionaler Ausgestaltung umfasst der Spannungsreferenz-Schaltkreis weiterhin einen vierten Widerstand R5, einen fünften und einen sechsten Bipolar-Transistor Q5, Q6 und einen zehnten und einen elften MOS-Transistor M10, M11. Der Drain-Anschluss des elften MOS-Transistors M11 ist direkt an den Betriebsspannungseingang und der Drain-Anschluss des zehnten MOS-Transistors M10 ist über den vierten Widerstand R5 an den Betriebsspannungseingang angeschlossen. Die Source-Anschlüsse des zehnten und des elften MOS-Transistors M10, M11 sind jeweils an die Kollektoren des fünften und des sechsten Bipolar-Transistors Q5, Q6 angeschlossen. Die Emitter des fünften und des sechsten Bipolar-Transistors Q5, Q6 sind an Masse angeschlossen. Die Basis des fünften Bipolar-Transistors Q5 ist an den Kollektor des fünften Bipolar-Transistors Q5 und die Basis des sechsten Bipolar-Transistors Q6 ist an den Kollektor des sechsten Bipolar-Transistors Q6 angeschlossen. Die Basis des sechsten Bipolar-Transistors Q6 ist weiterhin an den vierten Knoten angeschlossen.

Eine integrierte Schaltung mit einem Referenzspannungs-Schaltkreis entsprechend der vorliegenden Erfindung kann beispielsweise in einem Fahrzeug Verwendung finden.

In einer beispielhaften Ausführungsform der Erfindung signalisiert ein Spannungsreferenz-Schaltkreis über ein eigenes inhärentes Power-on-Reset-Signal verlässlich, wann die ihm zur Verfügung gestellte Betriebsspannung gerade hoch genug ist, sodass sein Referenzspannungs-Zielwert gerade erreicht ist. In dieser beispielhaften Ausführungsform sind hierfür weder eine zweite, interne oder externe Referenzspannung noch ein separater Power-on-Reset-Schaltkreis notwendig.

Im Folgenden wird die Funktion des in Figur 2 gezeigten Ausführungsbeispiels des erfindungsgemäß vorgeschlagenen Spannungsreferenz-Schaltkreises genauer beschrieben. Die beiden Bipolar-Transistoren Q1 und Q2, der IPTAT-Schaltungswiderstand R1 sowie der aus M1 und M2 gebildete Stromspiegel bewirken, dass sich Kollektorströme IC1, IC2 und Drain-Source-Ströme IDS1, IDS2 proportional zur absoluten Temperatur entsprechend denen der Schaltung in Figur 1 einstellen:

$$IC1 = IC2 = IDS1 = IDS2 = IPTAT = 1/R1 \times kT/q \times \ln(n).$$

Die Basis-Spannung UB von Q1 und Q2 wird von M4 geregelt. Ist der Strom IPTAT zu klein, so ist der Kollektor-Strom IC1 von Q1 aufgrund seiner um den Faktor n größeren Fläche höher als der von Q2, sodass das Gate von M4 von dem MOS-Transistor M2 nach oben gezogen wird und der Strom IPTAT steigt. Ist der Strom IPTAT zu groß, so ist der Kollektor-Strom IC1 aufgrund der Strom-Gegenkopplung von Q1 (hervorgerufen durch den IPTAT-Schaltungswiderstand R1) niedriger als der von Q2, sodass das Gate von M4 von dem Bipolar-Transistor Q2 nach unten gezogen wird und der Strom IPTAT sinkt. Es stellt sich bei gleicher Dimensionierung eine annähernd gleiche Basis-Spannung UB wie bei der Schaltung in Figur 1 ein.

Wegen M8 fließt der Strom IPTAT auch durch R4 und auch durch Q4, mit IR4 = IC4 = IPTAT (IB4 vernachlässigt). Da Q2 und Q4 gleich beschaffen sind, haben sie (bei Vernachlässigung von IB4) wegen IC2 = IC4 auch die gleiche Basis-Emitter-Spannung UBE2 = UBE4. Analog zu der Schaltung in Figur 1 kann ein Widerstand R4 gefunden werden, bei dem die Summe aus dem Spannungsabfall UR4 über R4 (aufgrund des durch ihn fließenden Kollektorstroms IC4 = IPTAT) und der Basis-Emitter-Spannung UBE4 in erster Näherung unabhängig von der Temperatur ist. Auch hier ergibt sich unabhängig von der verwendeten Halbleiter-Technologie an dem Ausgangs-Pin VBG wieder die Bandgap-Spannung von ca. 1,25 V.

Start-up-Schaltkreis

Zum Anlauf des Spannungsreferenz-Schaltkreises ist ein Start-up-Schaltkreis vorteilhaft. Der Start-up-Schaltkreis wird durch den Widerstand R5, die MOS-Transistoren M10, M11 und die Bipolar-Transistoren Q5, Q6 gebildet. Sobald die Betriebsspannung groß genug ist, fließt über den Widerstand R5, und die MOS-Transistoren M10 und Q5 der Strom IDS10. Bei gleicher Beschaffenheit von M10 und M11 sowie gleicher Beschaffenheit von Q5 und Q6 (und unter Vernachlässigung der Basisströme von Q1, Q2 und Q3) fließt der gleiche Strom auch durch die MOS-Transistoren M11 und Q6 (IDS11 = IDS10).

Der Widerstand R5 muss so dimensioniert werden, dass IDS11 << IPTAT über den gesamten Temperaturbereich gilt.

Da die Basen von Q1 und Q2 an die Basis von Q6 angeschlossen sind, fließen auch Kollektor-Ströme IC1 und IC2 durch die Bipolar-Transistoren Q1 und Q2. Solange die Bipolar-Transistoren Q1 und Q2 ihre Arbeitspunkte noch nicht erreicht haben, weil die Ströme IC1 und IC2 aufgrund einer zu geringen Betriebsspannung kleiner als der oben beschriebene Strom IPTAT sind, ist der Kollektor-Strom IC1 von Q1 aufgrund seiner um den Faktor n größeren Fläche höher als der von Q2, sodass das Gate von M4 von dem MOS-Transistor M2 nach oben gezogen wird und der Strom IPTAT weiter steigt, bis sich der oben beschriebene Arbeitspunkt einstellt und sich die Bandgap-Spannung von ca. 1,25 V ergibt.

Erzeugung eines Power-on-Reset-Signals

Der MOS-Transistor M4 muss den Kollektor-Strom für den sechsten Bipolar-Transistor Q6 und die Basis-Ströme für den ersten, zweiten, dritten und sechsten Bipolar-Transistor Q1, Q2, Q3, Q6 liefern. Das ist erst möglich, wenn die Betriebsspannung so groß ist, dass der dritte und der vierte MOS-Transistor M3, M4 und die Basis-Emitter-Strecken des ersten, zweiten, und sechsten Bipolar-Transistors Q1, Q2 und Q6 leiten. Der vom vierten MOS-Transistor M4 bereitgestellte Strom fließt aufgrund des aus dem dritten und fünften MOS-Transistor M3, M5 gebildeten Stromspiegels und bei gleicher Beschaffenheit von M3 und M5 auch durch den Pulldown-Widerstand R3 (IR3 = IDS5 = IDS3). Mit steigender Betriebsspannung steigt zunächst auch der Spannungsabfall über dem Pulldown-Widerstand R3. Sobald die Bipolar-Transistoren Q1 und Q2 ihren Arbeitspunkt erreicht haben, steigt der Spannungsabfall über dem Pulldown-Widerstand R3 nicht weiter. Der Spannungsabfall über dem Pulldown-Widerstand R3 kann auch nur soweit ansteigen, wie die Drain-Source-Sättigungs-Spannung des fünften MOS-Transistors M5 nicht unterschritten wird, sodass der fünfte MOS-Transistor M5 noch als Stromquelle arbeiten kann.

Der Spannungsabfall über dem Pulldown-Widerstand R3 kann entsprechend bis knapp an die Betriebsspannung heranreichen. Es kann ein Widerstandswert für den Pulldown-Widerstand R3 gefunden werden, dessen Spannungsabfall über diesen an dem Ausgang des Schmitt-Triggers X1 ein logisches High-Signal hervorruft, wenn der von dem vierten MOS-Transistor M4 bereitgestellte Strom ausreicht, sodass die Bipolar-Transistoren Q1 und Q2 zu leiten beginnen und die Regelung der Gate-Spannung einsetzt.

Da die Basis von Q6 mit den Basen von Q1 und Q2 verbunden ist, entspricht auch der Kollektor-Strom IC6 von Q6 dem von Q1 und Q2 (IC6 = IC1 = IC2 = IPTAT. Damit fließt (unter Vernachlässigung der Basis-Ströme von Q1, Q2, Q3 und Q6) der Strom IPTAT auch durch die MOS-Transistoren M4, M3 und M5 und den Pulldown-Widerstand R3 (IR3 = IDS5 = IDS3 = IDS4 = IC6 = IPTAT). Entsprechend ist der Spannungsabfall über R3 aufgrund der Temperaturabhängigkeit von IPTAT ebenfalls temperaturabhängig. Es kann daher vorteilhaft sein, in den Kollektor-Pfad von Q6 einen Widerstand R6 einzufügen, der den Kollektor-Strom von Q6 bei hohen Temperaturen begrenzt. Das kann einen größeren Wertebereich für den Pulldown-Widerstand R3 ermöglichen. Dann wäre die Basis von Q6 weiterhin mit dem Source-Anschluss von M11 verbunden und der Kollektor von Q6 wäre über den Widerstand R6 mit dem Source-Anschluss von M11 verbunden.

Ist die Betriebsspannung zu klein, so zieht der Pulldown-Widerstand R3 den Eingang des einen Schmitt-Triggers X1 zuverlässig auf Masse und dessen Ausgang führt ein logisches Low-Signal. Das nachfolgende NAND-Gatter X3 führt an seinem Ausgang dann ein logisches High-Signal. Der Ausgang des NAND-Gatters X3 ist das Power-on-Reset-Signal RST. Das Power-On-Reset-Signal RST kann erst auf Low gehen, wenn auch der andere Schmitt-Trigger X2 an seinem Ausgang ein High-Signal führt. Dazu ist es erforderlich, dass die Betriebsspannung so groß ist, dass der achte und der neunte MOS-Transistor M8 und M9 leiten und die Drain-Source-Ströme IDS8 und IDS9 und der Kollektor-Strom IC4 dem von IC1 = IC2 = IPTAT entsprechen. Das ist dann der Fall, wenn die Drain-Source-Sättigungs-Spannung des achten MOS-Transistors M8 nicht unterschritten wird, sodass der achte MOS-Transistor M8 ohne Beeinträchtigung als Strom-Quelle arbeiten kann und wenn sich eine Gate-Source-Spannung des neunten MOS-Transistors M9 einstellen kann, die entsprechend der Kennlinie IDS9 (UGS9) des neunten MOS-Transistors M9 den Drain-Source-Strom IDS9 = IPTAT führen kann und wenn der vierte Bipolar-Transistor Q4 entsprechend seiner Kennlinie IC4 (UBE4) den Kollektor-Strom IC4 = IPTAT führen kann. Aufgrund des Faktors a, wobei a etwas größer als eins ist (zum Beispiel $\alpha$ = 1.1 oder $\alpha$ = 1.2), ist die Stromquelle M6 etwas stärker als die Stromquelle Q3, sodass der Eingang des anderen Schmitt-Triggers X2 von M6 auf einen Wert nahe der Betriebsspannung gezogen wird, sobald der Strom IPTAT durch M8, M9, R4 und Q4 fließen kann und sobald die Drain-Source-Sättigungs-Spannung des sechsten MOS-Transistors M6 nicht unterschritten wird, sodass auch der sechste MOS-Transistor M6 ohne Beeinträchtigung als Stromquelle arbeiten kann und einen Strom IDS6 = $\alpha \times$ IPTAT > IC3 = IPTAT bereitstellen kann. Das passiert in etwa, wenn die Referenzspannung VBG gerade ihren Zielwert von 1,25 V erreicht hat. Durch einen Faktor $\beta$ > 1 (zum Beispiel $\beta$ = 2 oder $\beta$ = 4) kann dieser Schaltpunkt immer weiter zu kleinen Abständen vom Zielwert verschoben werden, weil hierdurch (bei größer werdendem Faktor $\beta$) die Gate-Source-Spannung von M9 gegenüber der Gate-Source-Spannung von M7 verkleinert werden kann und damit gleichzeitig die Drain-Source-Spannung von M6 reduziert werden kann. Die Drain-Source-Spannung von M6 wird von der Gate-Source-Spannung von M7 und der Gate-Source-Spannung von M9 beeinflusst. Da die Gates von M7 und M9 miteinander verbunden sind, ergibt sich, dass die Summe aus Drain-Source-Spannung von M6 und Gate-Source-Spannung von M7 der Summe aus Drain-Source-Spannung von M8 und Gate-Source-Spannung von M9 entspricht (UDS6 + UGS7 = UDS8 + UGS9). Solange der Strom IPTAT nicht durch M8, M9, R4 und Q4 fließen kann, weil die Drain-Source-Sättigungs-Spannung von M8 unterschritten wird, solange kann auch der Strom $\alpha \times$ IPTAT nicht von M6 bereitgestellt werden, weil wegen UDS6 + UGS7 = UDS8 + UGS9 dann auch die Drain-Source-Sättigungs-Spannung von M8 unterschritten wird und M8 dann nicht ohne Beeinträchtigung als Stromquelle arbeiten kann. Die Drain-Source-Sättigungs-Spannung kann bei geeigneter Dimensionierung bei ca. 200 mV liegen.

Auf diese Weise signalisiert der hier vorgeschlagene Spannungsreferenz-Schaltkreis über das Power-on-Reset-Signal RST seine Betriebsbereitschaft beim Erreichen des Zielwertes der Referenzspannung in Abhängigkeit von der angelegten Betriebsspannung mit einem Low-Pegel. Bei zu geringer Betriebsspannung ist das RST-Signal zuverlässig High.

Dies gilt ab einer Betriebsspannung, die ausreicht, um ein NAND-Gatter und einen Schmitt-Trigger zu betreiben, also ab einer Betriebsspannung, die beispielsweise die Schwellspannung eines PMOS-Transistors oder die eines NMOS-Transistors übersteigt, je nachdem, welche der beiden Schwellspannungen größer ist. Diese untere Grenze, ab der das Power-On-Reset-Signal seine Gültigkeit erlangt, stellt in der Praxis keinen Nachteil dar und ist insbesondere für einen digitalen Schaltkreis oder den Digitalteil eines ASIC völlig ausreichend. Das Power-on-Reset-Signal RST kann jedoch auch leicht mit einem nachgeschalteten Inverter, bestehend aus einem MOS-Transistor und einem Widerstand in ein Signal umgewandelt werden, welches bereits ab der Betriebsspannung von 0 V gültig ist. Sobald dieses Signal aber ein einziges logisches Gatter (zum Beispiel einen Inverter, ein ODER-Gatter oder ein UND-Gatter) passiert, würde für die Betriebsspannung, ab der das Signal gültig ist, wieder die untere Grenze einer Schwellspannung eines PMOS-Transistors beziehungsweise eines NMOS-Transistors gelten, je nachdem, welche der beiden Schwellspannungen größer ist.

Der Temperaturgang dieser Spannungsreferenz kann über den IPTAT-Schaltungswiderstand R1 oder den dritten Widerstand R4 abgeglichen werden. Ein separater Abgleich der Power-on-Reset-Schwelle ist nicht erforderlich. Der hier vorgeschlagene Spannungsreferenz-Schaltkreis wird das Erreichen des Referenzspannungs-Zielwertes immer zuverlässig signalisieren.

Der Widerstand R4 kann in die Reihenschaltung zweier Widerstände R4A und R4B aufgeteilt werden, die so einen Spannungsteiler bilden. Die Gates von M7 und M9 können an den Ausgang dieses Spannungsteilers (also zwischen R4A und R4B) angeschlossen werden. Auf diese Weise kann die Referenzspannung bei geeigneter Dimensionierung dieses Spannungsteilers bereits bei einer kleineren Betriebsspannung ihren Zielwert erreichen.

Für die MOS-Transistoren M1, M2, M6 und M8 und/oder die Bipolar-Transistoren Q1 und Q2 können jeweils auch Kaskode-Transistoren verwendet werden. Dadurch kann vorteilhaft die Betriebsspannungsunterdrückung erhöht werden.

Das Größenverhältnis von Q1 / Q2 kann gleich n/m gewählt werden, wobei n und m natürliche Zahlen sind mit m > 1 und n > 1. Die Bipolar-Transistoren Q3, Q5 und Q6 erhalten den Größenfaktor 1. Q4 bekommt den Größenfaktor m. Auf diese Weise können die Kollektor-Ströme der Bipolar-Transistoren Q3, Q5 und Q6 gegenüber denen der Bipolar-Transistoren Q1, Q2 und Q4 reduziert werden, um die Gesamtverlustleistung des Schaltkreises herabzusetzen.

Da der Stromverbrauch dieses Spannungsreferenz-Schaltkreises im einstelligen µA-Bereich liegen kann, kann ein RC-Filter an einen Längswiderstand im Bereich von einigen 10 ... 100 kΩ als Eingangsfilter für die Betriebsspannung verwendet werden.

Ein Zeitglied kann die fallende Flanke des RST-Signals verzögern, um auch bei kleineren kürzeren Einbrüchen der Betriebsspannung eine definierte Power-on-Reset-Phase zu realisieren.

Die Erfindung hilft, ein sehr verbreitetes immer wiederkehrendes Problem im Hoch- und Runterlauf von anwendungsspezifischen und anderen integrierten Schaltungen zu beheben.

In einer beispielhaften Ausführungsform der Erfindung signalisiert ein Spannungsreferenz-Schaltkreis über ein eigenes inhärentes Power-on-Reset-Signal verlässlich, wann die ihm zur Verfügung gestellte Betriebsspannung gerade hoch genug ist, sodass sein Referenzspannungs-Zielwert gerade erreicht ist. In dieser beispielhaften Ausführungsform ist hierfür weder eine zweite, interne oder externe Referenzspannung noch ein separater Power-on-Reset-Schaltkreis notwendig.

**Patentansprüche**

1. Spannungsreferenz-Schaltkreis (100) zur Bereitstellung einer Referenzspannung (VBG) für eine anwendungsspezifische integrierte Schaltung, umfassend: einen Spannungseingang zum Anlegen einer Betriebsspannung, einen Masseanschluss, einen Spannungsausgang zur Bereitstellung einer Referenzspannung (VBG) und einen Signalausgang zur Bereitstellung eines Power-on-Reset-Signals (RST), wobei der Spannungsreferenz-Schaltkreis (100) eine zwischen Spannungseingang und Masseanschluss angeschlossene IPTAT-Schaltung zur Erzeugung eines zur absoluten Temperatur proportionalen Stroms umfasst, **dadurch gekennzeichnet, dass** der Spannungsreferenz-Schaltkreis (100) ausgebildet ist, das Power-on-Reset-Signal (RST) nur bereitzustellen, wenn die Referenzspannung einen Zielwert erreicht hat und wenn zusätzlich in der IPTAT- Schaltung ein Strom mit einer Stromstärke fließt, die eine durch einen Spannungswert der Betriebsspannung und einen Pulldown-Widerstandswert bestimmte Mindeststromstärke erreicht oder überschreitet.

2. Spannungsreferenz-Schaltkreis (100) nach Anspruch 1, wobei die IPTAT-Schaltung einen ersten und einen zweiten Bipolar-Transistor (Q1, Q2) mit unterschiedlichen Strom-Spannungs-Kennlinien, wobei der erste Bipolar-Transistor (Q1) größer als der zweite Bipolar-Transistor (Q2) ist, einen IPTAT-Schaltungswiderstand (R1), wobei der Emitter des ersten Bipolar-Transistors (Q1) über den IPTAT-Schaltungswiderstand (R1) mit dem Masseanschluss verbunden und wobei der Emitter des zweiten Bipolar-Transistors (Q2) direkt mit dem Masseanschluss verbunden ist, einen ersten Stromspiegel (M1, M2), der den durch den ersten Bipolar-Transistor (Q1) fließenden Strom auf einen ersten Strompfad abbildet, der den zweiten Bipolar-Transistor (Q2) umfasst, einen zweiten Stromspiegel (M3, M5), einen vierten MOS-Transistor (M4) und einen sechsten Bipolar-Transistor (Q6) umfasst, wobei ein Drain-Anschluss des vierten MOS-Transistors (M4) mit dem Spannungseingang, ein Gate-Anschluss des vierten MOS-Transistors (M4) mit einem Kollektor des zweiten Bipolar-Transistors (Q2) und ein Source-Anschluss des vierten MOS-Transistors (M4) mit den Basen des ersten des zweiten und des sechsten Bipolar-Transistors (Q1, Q2, Q6) verbunden ist, wobei der Spannungsreferenz-Schaltkreis (100) weiterhin einen zweiten Strompfad zwischen dem Spannungseingang und dem Masseanschluss umfasst, wobei ein Emitter des sechsten Bipolar-Transistors (Q6) mit dem Masseanschluss verbunden ist und ein Kollektor des sechsten Bipolar-Transistors (Q6) mit der Basis des sechsten Bipolar-Transistors (Q6) verbunden ist, wobei der zweite Strompfad einen Pulldown-Widerstand (R3) mit dem Pulldown-Widerstandswert umfasst und wobei der zweite Stromspiegel (M3, M5) einen durch den vierten MOS-Transistor (M4) fließenden Strom auf den zweiten Strompfad abbildet, wobei der Pulldown-Widerstandswert (R3) so gewählt ist, dass ein Spannungsabfall über den Pulldown-Widerstand (R3) nicht weiter ansteigt, wenn der durch den vierten MOS-Transistor (M4) fließende Strom so hoch ist, dass der erste und der zweite Bipolar-Transistor (Q1, Q2) leiten.

3. Spannungsreferenz-Schaltkreis (100) nach Anspruch 2, weiterhin umfassend einen dritten Strompfad zwischen dem Spannungseingang und dem Masseanschluss und einen dritten Stromspiegel (M1, M6), wobei der dritte Strompfad einen dritten Bipolar-Transistor (Q3) umfasst, wobei der dritte Stromspiegel (M1, M6) einen weiteren Strom, der durch den ersten Bipolar-Transistor (Q1) fließt, vergrößert auf den dritten Strompfad abbildet und wobei der Source-Anschluss des vierten MOS-Transistors (M4) mit einer Basis des dritten Bipolar-Transistors (Q3) verbunden ist.

4. Spannungsreferenz-Schaltkreis (100) nach Anspruch 3, weiterhin umfassend einen ersten Schmitt-Trigger (X1), der mit einem ersten Knoten auf dem zweiten Strompfad verbunden ist, wobei der erste Knoten zwischen dem Stromspiegel (M3, M5) und dem Pulldown-Widerstand (R3) angeordnet ist und einen zweiten Schmitt-Trigger (X2), der mit einem zweiten Knoten auf dem dritten Strompfad verbunden ist, wobei der zweite Knoten zwischen dem dritten Stromspiegel (M1, M6) und dem dritten Bipolar-Transistor (Q3) angeordnet ist.

5. Spannungsreferenz-Schaltkreis (100) nach Anspruch 4, weiterhin umfassend ein NAND-Gatter, wobei Ausgänge des ersten und des zweiten Schmitt-Triggers (X1, X2) mit Eingängen des NAND-Gatters verbunden sind und wobei ein Ausgang des NAND-Gatters mit dem Signalausgang zur Bereitstellung eines Power-on-Reset-Signals (RST) verbunden ist.

6. Spannungsreferenz-Schaltkreis (100) nach Anspruch 3, 4 oder 5, weiterhin umfassend einen vierten Strompfad zwischen dem Spannungseingang und dem Masseanschluss und einen vierten Stromspiegel (M1, M8), wobei der vierte Strompfad einen weiteren Widerstand (R4) und einen vierten Bipolar-Transistor (Q4) in Reihe geschaltet umfasst, wobei Basis und Kollektor des vierten Bipolar-Transistors (Q4) miteinander verbunden sind und wobei der vierte Stromspiegel (M1, M8) den weiteren Strom auf den vierten Strompfad abbildet, weiterhin umfassend noch einen weiteren Knoten auf dem vierten Strompfad, der zwischen dem vierten Stromspiegel (M1, M8) und dem weiteren Widerstand (R4) angeordnet und mit dem Spannungsausgang zur Bereitstellung einer Referenzspannung (VBG) verbunden ist.

7. Spannungsreferenz-Schaltkreis (100) nach Anspruch 6, weiterhin umfassend einen fünften Stromspiegel (M9, M7), der das durch den vierten Strompfad fließende Abbild des weiteren Stroms verkleinert auf den dritten Strompfad abbildet.

8. Spannungsreferenz-Schaltkreis nach einem der vorangehenden Ansprüche, weiterhin umfassend ein RC-Filter zur Filterung der Betriebsspannung, wobei das RC-Filter an den Spannungseingang angeschlossen ist.

9. Spannungsreferenz-Schaltkreis nach einem der vorangehenden Ansprüche, weiterhin umfassend ein Zeitglied zur Verzögerung des Power-on-Reset-Signals.

10. Fahrzeug mit einer integrierten Schaltung an einem Referenzspannungs-Schaltkreis nach einem der vorangehenden Ansprüche.

**Claims**

1. Voltage reference circuit (100) for providing a reference voltage (VBG) for an application-specific integrated circuit, comprising: a voltage input for applying an operating voltage, an earth connection, a voltage output for providing a reference voltage (VBG) and a signal output for providing a power-on reset signal (RST), wherein the voltage reference circuit (100) comprises an IPTAT circuit, connected between the voltage input and the earth connection, for generating a current that is proportional to the absolute temperature, **characterized in that** the voltage reference circuit (100) is designed to provide the power-on reset signal (RST) only if the reference voltage has reached a target value and if a current with a current intensity that reaches or exceeds a minimum current intensity determined by a voltage value of the operating voltage and a pull-down resistance value is additionally flowing in the IPTAT circuit.

2. Voltage reference circuit (100) according to Claim 1, wherein the IPTAT circuit comprises a first and a second bipolar transistor (Q1, Q2) with different current/voltage characteristics, wherein the first bipolar transistor (Q1) is larger than the second bipolar transistor (Q2), an IPTAT circuit resistor (R1), wherein the emitter of the first bipolar transistor (Q1) is connected to the earth connection via the IPTAT circuit resistor (R1), and wherein the emitter of the second bipolar transistor (Q2) is connected to the earth connection directly, a first current mirror (M1, M2) that maps the current flowing through the first bipolar transistor (Q1) to a first current path that comprises the second bipolar transistor (Q2), a second current mirror (M3, M5), a fourth MOS transistor (M4) and a sixth bipolar transistor (Q6), wherein a drain connection of the fourth MOS transistor (M4) is connected to the voltage input, a gate connection of the fourth MOS transistor (M4) is connected to a collector of the second bipolar transistor (Q2) and a source connection of the fourth MOS transistor (M4) is connected to the bases of the first, the second and the sixth bipolar transistor (Q1, Q2, Q6), wherein the voltage reference circuit (100) furthermore comprises a second current path between the voltage input and the earth connection, wherein an emitter of the sixth bipolar transistor (Q6) is connected to the earth connection and a collector of the sixth bipolar transistor (Q6) is connected to the base of the sixth bipolar transistor (Q6), wherein the second current path comprises a pull-down resistor (R3) with the pull-down resistance value, and wherein the second current mirror (M3, M5) maps a current flowing through the fourth MOS transistor (M4) to the second current path, wherein the pull-down resistance value (R3) is chosen such that a voltage drop across the pull-down resistor (R3) does not rise further if the current flowing through the fourth MOS transistor (M4) is so high that the first and the second bipolar transistor (Q1, Q2) are on.

3. Voltage reference circuit (100) according to Claim 2, furthermore comprising a third current path between the voltage input and the earth connection and a third current mirror (M1, M6), wherein the third current path comprises a third bipolar transistor (Q3), wherein the third current mirror (M1, M6) maps a further current that is flowing through the first bipolar transistor (Q1) to the third current path in a magnified manner, and wherein the source connection of the fourth MOS transistor (M4) is connected to a base of the third bipolar transistor (Q3) .

4. Voltage reference circuit (100) according to Claim 3, furthermore comprising a first Schmitt trigger (X1) that is connected to a first node on the second current path, wherein the first node is arranged between the current mirror (M3, M5) and the pull-down resistor (R3), and a second Schmitt trigger (X2) that is connected to a second node on the third current path, wherein the second node is arranged between the third current mirror (M1, M6) and the third bipolar transistor (Q3).

5. Voltage reference circuit (100) according to Claim 4, furthermore comprising a NAND gate, wherein outputs of the first and the second Schmitt trigger (X1, X2) are connected to inputs of the NAND gate, and wherein an output of the NAND gate is connected to the signal output for providing a power-on reset signal (RST).

6. Voltage reference circuit (100) according to Claim 3, 4 or 5, furthermore comprising a fourth current path between the voltage input and the earth connection and a fourth current mirror (M1, M8), wherein the fourth current path comprises a further resistor (R4) and a fourth bipolar transistor (Q4) connected in series, wherein the base and the collector of the fourth bipolar transistor (Q4) are connected to one another, and wherein the fourth current mirror (M1, M8) maps the further current to the fourth current path, furthermore comprising yet another node on the fourth current path that is arranged between the fourth current mirror (M1, M8) and the further resistor (R4) and is connected to the voltage output for providing a reference voltage (VBG).

7. Voltage reference circuit (100) according to Claim 6, furthermore comprising a fifth current mirror (M9, M7) that maps the image of the further current that is flowing through the fourth current path to the third current path in a demagnified manner.

8. Voltage reference circuit according to one of the preceding claims, furthermore comprising an RC filter for filtering the operating voltage, wherein the RC filter is connected to the voltage input.

9. Voltage reference circuit according to one of the preceding claims, furthermore comprising a timer for delaying the power-on reset signal.

10. Vehicle having an integrated circuit on a reference voltage circuit according to one of the preceding claims.

**Revendications**

1. Circuit de référence de tension (100) permettant de fournir une tension de référence (VBG) pour un circuit intégré spécifique à une application, comprenant : une entrée de tension pour appliquer une tension de service, une borne de masse, une sortie de tension pour fournir une tension de référence (VBG) et une sortie de signal pour fournir un signal de réinitialisation à la mise sous tension (RST), le circuit de référence de tension (100) comprenant un circuit IPTAT connecté entre l'entrée de tension et la borne de masse pour générer un courant proportionnel à la température absolue,

**caractérisé en ce que** le circuit de référence de tension (100) est réalisé pour fournir le signal de réinitialisation à la mise sous tension (RST) uniquement si la tension de référence a atteint une valeur cible et si en plus dans le circuit IPTAT passe un courant d'une intensité de courant qui atteint ou dépasse une intensité de courant minimale déterminée par une valeur de tension de la tension de service et une valeur de résistance de tirage vers le bas.

2. Circuit de référence de tension (100) selon la revendication 1, dans lequel le circuit IPTAT comprend un premier et un deuxième transistor bipolaire (Q1, Q2) avec différentes courbes caractéristiques courant/tension, le premier transistor bipolaire (Q1) étant plus grand que le deuxième transistor bipolaire (Q2), une résistance de circuit IPTAT (R1), l'émetteur du premier transistor bipolaire (Q1) étant relié à la borne de masse par l'intermédiaire de la résistance de circuit IPTAT (R1), et l'émetteur du deuxième transistor bipolaire (Q2) étant relié directement à la borne de masse, un premier miroir de courant (M1, M2) qui mappe le courant passant par le premier transistor bipolaire (Q1) sur un premier trajet de courant qui comprend le deuxième transistor bipolaire (Q2), un deuxième miroir de courant (M3, M5), un quatrième transistor MOS (M4) et un sixième transistor bipolaire (Q6), une borne de drain du quatrième transistor MOS (M4) étant reliée à l'entrée de tension, une borne de grille du quatrième transistor MOS (M4) étant reliée à un collecteur du deuxième transistor bipolaire (Q2), et une borne de source du quatrième transistor MOS (M4) étant reliée aux bases du premier, du deuxième et du sixième transistor bipolaire (Q1, Q2, Q6), dans lequel le circuit de référence de tension (100) comprend en outre un deuxième trajet de courant entre l'entrée de tension et la borne de masse, un émetteur du sixième transistor bipolaire (Q6) étant relié à la borne de masse, et un collecteur du sixième transistor bipolaire (Q6) étant relié à la base du sixième transistor bipolaire (Q6), le deuxième trajet de courant comprenant une résistance de tirage vers le bas (R3) ayant la valeur de résistance de tirage vers le bas, et le deuxième miroir de courant (M3, M5) mappant un courant passant par le quatrième transistor MOS (M4) sur le deuxième trajet de courant, la valeur de résistance de tirage vers le bas (R3) étant sélectionnée de telle sorte qu'une chute de tension à travers la résistance de tirage vers le bas (R3) n'augmente plus si le courant passant par le quatrième transistor MOS (M4) est si élevé que le premier et le deuxième transistor bipolaire (Q1, Q2) sont conducteurs.

3. Circuit de référence de tension (100) selon la revendication 2, comprenant en outre un troisième trajet de courant entre l'entrée de tension et la borne de masse et un troisième miroir de courant (M1, M6), le troisième trajet de courant comprenant un troisième transistor bipolaire (Q3), le troisième miroir de courant (M1, M6) mappant de manière augmentée un autre courant passant par le premier transistor bipolaire (Q1) sur le troisième trajet de courant, et la borne de source du quatrième transistor MOS (M4) étant reliée à une base du troisième transistor bipolaire (Q3).

4. Circuit de référence de tension (100) selon la revendication 3, comprenant en outre une première bascule de Schmitt (X1) qui est reliée à un premier nœud sur le deuxième trajet de courant, le premier nœud étant disposé entre le miroir de courant (M3, M5) et la résistance de tirage vers le bas (R3), et une deuxième bascule de Schmitt (X2) qui est reliée à un deuxième nœud sur le troisième trajet de courant, le deuxième nœud étant disposé entre le troisième miroir de courant (M1, M6) et le troisième transistor bipolaire (Q3).

5. Circuit de référence de tension (100) selon la revendication 4, comprenant en outre une grille NAND, les sorties de la première et de la deuxième bascule de Schmitt (X1, X2) étant reliées aux entrées de la grille NAND, et une sortie de la grille NAND étant reliée à la sortie de signal pour fournir un signal de réinitialisation à la mise sous tension (RST).

6. Circuit de référence de tension (100) selon la revendication 3, 4 ou 5, comprenant en outre un quatrième trajet de courant entre l'entrée de tension et la borne de masse et un quatrième miroir de courant (M1, M8), le quatrième trajet de courant comprenant une autre résistance (R4) et un quatrième transistor bipolaire (Q4) connectés en série, la base et le collecteur du quatrième transistor bipolaire (Q4) étant reliés l'un à l'autre, et le quatrième miroir de courant (M1, M8) mappant l'autre courant sur le quatrième trajet de courant, comprenant en outre encore un autre nœud sur le quatrième trajet de courant qui est disposé entre le quatrième miroir de courant (M1, M8) et l'autre résistance (R4) et relié à la sortie de tension pour fournir une tension de référence (VBG).

7. Circuit de référence de tension (100) selon la revendication 6, comprenant en outre un cinquième miroir de courant (M9, M7) qui mappe de manière diminuée sur le troisième trajet de courant le mappage de l'autre courant passant par le quatrième trajet de courant.

8. Circuit de référence de tension selon l'une quelconque des revendications précédentes, comprenant en outre un filtre RC pour filtrer la tension de service, le filtre RC étant connecté à l'entrée de tension.

9. Circuit de référence de tension selon l'une quelconque des revendications précédentes, comprenant en outre un relais temporisateur pour retarder le signal de réinitialisation à la mise sous tension.

10. Véhicule comprenant un circuit intégré sur un circuit de tension de référence selon l'une quelconque des revendications précédentes.

# Fig. 1

## Stand der Technik

Fig. 2

EP 3 740 837 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2013120026 A1